# EUROPEAN PATENT APPLICATION

(11) **EP 2 068 603 A2**
(43) Date of publication of application: **10.06.2009**
(21) Application number: 08163498.2
(22) Date of filing: 02.09.2008
(51) Int. Cl.: H05K 1/18, H05K 3/30

(54) **Large electronic component dampening fixation**

(30) Priority: 07.09.2007 US 899795
(71) Applicant: Delphi Technologies, Inc., Troy, Michigan 48007 (US)
(72) Inventor: Kerr, Geoffrey Howard, Ormskirk, Lancashire L39 3NU (GB); Hogan, Michael P., Carmel, IN 46033 (US)
(74) Representative: Denton, Michael John

(57) **Abstract**

An electronic assembly having a large or massive electronic component mounted to a circuit substrate is stabilized against movement due to shock and/or vibration by an elastic dampening member disposed between the large electronic component and a clamping member that compresses the dampening member between the clamping member and the electronic component and urges opposite end walls of the dampening member against opposite sidewalls of the electronic component to securely grip the electronic component between the opposite end walls of the dampening member. The arrangement is effective for reducing and/or eliminating damage and subsequent failure due to exposure of the electronic assembly to shock and/or vibration.

## Description

### Technical Field

This invention relates to electronic assemblies having a large electronic component mounted to a circuit board, and more particularly to electronic assemblies subjected to a vibration environment.

### Background of the Invention

Large electronic components having electrical leads soldered to a circuit substrate are vulnerable to damage when subjected to repeated shock and/or vibration which cause relative movement of the large electronic components with respect to the circuit substrate. Such movement places stresses on the solder joints. These stresses can eventually result in failure of the electrical connection. Without some means of dampening the effects of shock and/or vibration, unsatisfactorily high failure rates could occur for certain types of electronic assemblies used in environments in which the electronic assemblies are exposed to substantial shock and vibration, especially repeated and frequent shock and/or vibration. For example, electronic assemblies used in certain automotive applications, such as engine control units (ECUs) and engine control modules (ECMs) are typically provided with dampening means for reducing the deleterious effects of shock and vibration.

One technique for preventing damage and failure due to shock and/or vibration of an electronic assembly having a large electronic component soldered to a circuit substrate is to adhesively bond a surface of the electronic component to a housing or case for the assembly. This solution is not entirely satisfactory because adhesive materials have a coefficient of thermal expansion that is substantially different from the coefficient of thermal expansion of the body of the electronic component and substantially different from the coefficient of thermal expansion of the housing or other component to which the electronic component is adhesively bonded. These differences in coefficients of thermal expansion will cause the adhesive to expand and contract in response to temperature changes in a manner that is different from that of the other components of the assembly. More specifically, the adhesive will tend to expand and contract at a different rate than the body of the electronic component and the body of the housing or other assembly component to which the body of the electronic component is adhered. These differences in the rates of expansion of the different materials will induce relative movement of the body of the electronic component with respect to the circuit substrate creating stresses on the solder joints. The stresses on the solder joints can result in cracking of the solder joints and failure of the electronic assembly. In addition, most adhesives tend to shrink during cure because of physical changes to the adhesive material, or contract after cooling down from the cure oven. These changes in geometry, can also cause stresses on solder joints and result in failure of the electronic assembly.

Another technique for preventing damage and failure due to shock and/or vibration of an electronic assembly having a large electronic component soldered to a circuit substrate is to retain the large electronic component between opposite end plates welded or otherwise fixed to the body of the large electronic component and to the circuit substrate. However, the shock and/or vibration can often be sufficiently severe to cause the weld or other fixation to become broken, resulting in failure of the electronic assembly.

### Summary of the Invention

The invention provides an improved electronic assembly in which an elastic dampening member and a clamping arrangement are utilized to stabilize an electronic component against lateral movement without imposing any substantial stresses on the solder joints.

In accordance with an aspect of the invention, an electronic assembly includes a circuit substrate, an electronic component, an elastic dampening member, and a clamping member that compresses the dampening member between the clamping member and the electronic component. In accordance with this aspect of the invention, the dampening member has a top section engaging an upper surface of the electronic component and opposite end walls that extend downwardly from the top section of the dampening member and engage opposite sidewalls of the body of the electronic component. Further, in accordance with this aspect of the invention the clamping member urges the opposite end walls of the dampening member against the opposite sidewalls of the electronic component.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a cross-sectional view of an electronic assembly in accordance with the invention.
FIG. 2 is a perspective view of an electronic component (e.g., a capacitor) having supporting end plates that stabilize the electronic component against motion that exerts stresses as solder joints.
FIG. 3 is a cross-sectional view of an alternative electronic assembly in accordance with invention.
FIG. 4 is a top perspective view of an elastic dampening member used in the assembly shown in FIG. 3
FIG. 5 is a bottom perspective view of the elastic dampening member used in the assembly shown in FIG. 3.

### Description of the Preferred Embodiments

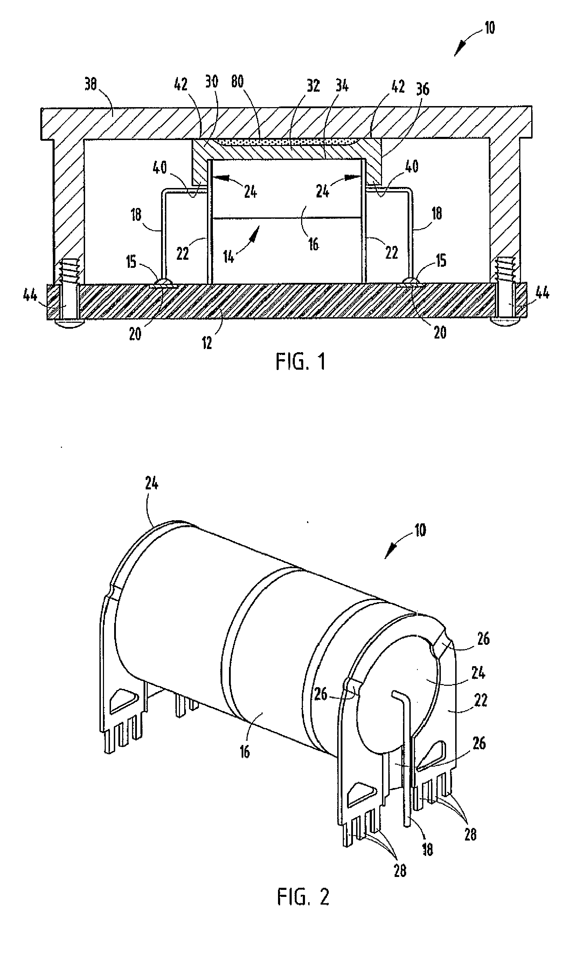

Shown in FIG. 1 is a cross-sectional view of an electronic assembly 10 employing a shock and/or vibration dampening structure in accordance with the invention. The assembly includes a circuit substrate 12 to which an electronic component 14 is mechanically attached and electrically connected by solder joints 15. Electronic component 14 includes a body 16 and electrical leads 18. Typically, circuit substrate 12 is provided with openings (not shown) for receiving the distal ends of leads 18, and contact pads 20.

In the illustrated embodiment, body 16 of electronic component 14 is also secured to circuit substrate 12 with supporting end plates 22 which are welded to opposite sidewalls 24 at weld joints 26 (as shown in FIG. 2). The bottom end or feet 28 of end plates 22 can be welded to circuit substrate 12, whereby electrical component 14 is securely affixed to circuit substrate 12 and exhibits some resistance to damage and failure upon repeated shock and vibration. However, securing electronic component 14 to circuit substrate 12 with end plates 22 does not always provide sufficient resistance to damage and failure of the electronic assembly when the assembly is subjected to severe shock and/or vibration of the type that is commonly encountered in automotive applications. More specifically, the severe shock and vibration that electronic assemblies are subjected to in automotive applications can cause failure of the weld joints, resulting in a separation of the body 16 of electronic component 14 from supporting end plates 22, and subsequent cracking or other damage to solder joints 15 and failure of electronic assembly 10. In order to prevent such damage, electronic assembly 10 includes an elastic dampening member 30. Dampening member 30 includes a top section 32 that engages an upper surface 34 of body 16 of electronic component 14. Upper surface 34 of cylindrical body 16 (shown in FIGs. 1 and 2) refers generally to a surface area that faces upwardly in a direction away from circuit substrate 12 (i.e., a surface area opposite the surface area facing circuit substrate 12). Dampening member 30 also includes opposite end walls 36 that extend downwardly from top section 32 and engage opposite sidewalls 24 of body 16 of electronic component 14. Elastic dampening member 30 is sized and configured to fit snugly over body 16 electronic component 14 by slightly stretching elastic member 30, thereby providing an initial good grip of body 16 by elastic dampening member 30.

A rigid clamping member 38 forcefully engages an upper surface of the opposite end walls 36, and thereby urges lower ends 40 of end walls 36 of dampening member 30 against the sidewalls 24 of the body 16 of electronic component 14. This can be accomplished for example by having the upper surfaces 42 of dampening member 30 atop end walls 36 sloped slightly toward each other (i.e., sloped toward top section 32).

In the illustrated embodiment of FIG. 1, clamping member 38 is a housing member which may be secured to circuit substrate 12 with fasteners such as screws 44, such that housing member 38 together with circuit substrate 12 defines an enclosure to contain and/or provide a protective environment for electronic component 14 and/or other components mounted on or defined on circuit substrate 12.

In the electronic assembly shown in FIG. 1, body 16 of electronic component 14 has a generally cylindrical shape and is fixed to circuit substrate 12 with the cylinder axis arranged parallel with the upper surface of circuit substrate 12 to which electronic component 14 is mounted. However, there are aspects of the invention that may be employed with other large electronic components having different shapes and/or different orientations. Further, electronic components that may be stabilized against shock and vibration include capacitors (as illustrated), resistors, transistors, diodes, etc. In general, the principles of the invention may be applied to stabilize any electronic component mounted to a circuit substrate against damage and failure due to shock and vibration, and is particularly applicable to larger or heavier (i.e., more massive) electronic components that acquire sufficient momentum during shock and vibration to transmit destructive forces through the electrical leads to solder joints on the circuit substrate.

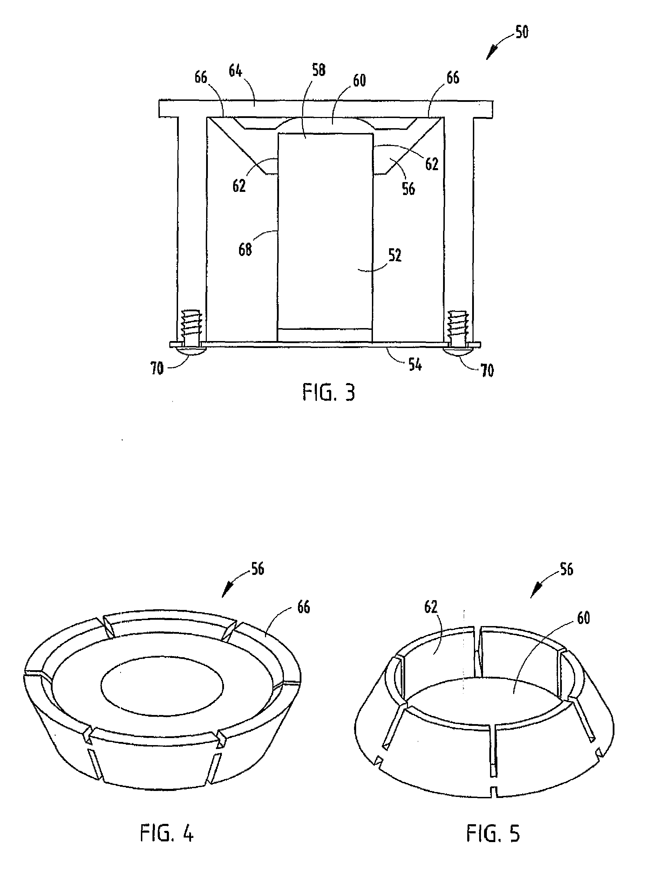

In FIG. 3, there is shown an alternative arrangement for an electronic assembly 50 having a cylindrical electronic component (e.g., a capacitor) mounted on a circuit substrate 54 with the cylindrical axis of the electronic component arranged perpendicular to the surface of circuit substrate 54 to which electronic component 52 is mounted. In this example, an inverted cup-shaped dampening member 56 is fitted to the top end of electronic component 52. Dampening member 56 is an elastic material that is configured to be stretched to snugly fit over the top end 58 of electronic component 52, and as with dampening member 30 shown in FIGs. 1 and 2, includes a top section 60 and end walls 62 that extend downwardly from top section 60 and engage the cylindrical sidewall of electronic component 52. A clamping member (or housing member) 64 engages upper surfaces 66 of dampening member 56, compressing end walls 62 downwardly and inwardly toward an upper surface area of cylindrical sidewall 68 of component 52, thereby forcefully engaging such surfaces at opposite wall surfaces, whereby the electronic component is securely gripped between opposite end walls 62 of dampening member 56, without exerting substantial force in the vertical direction while stabilizing component 52 against lateral movement when assembly 50 is subjected to shock and/or vibration. As with the assembly 10 shown in FIG. 1, clamping member 64 may be a housing member secured to circuit substrate 54 with fasteners 70 (e.g., screws).

Details of dampening member 56 are illustrated in FIGs. 4 and 5 which show a top view and a bottom or underside view, respectively, of elastic dampening member 56.

The circuit substrates which may be employed with the invention encompass generally any printed circuit board or wiring board on which conductive traces may be defined and on which electronic components may be mounted or formed.

The dampening members employed in the invention are elastic in the sense that they are relatively resiliently deformable as compared with the relatively more rigid clamping members or housing members. The elastic dampening members may comprise an elastomer (e.g., an elastic polymer), such as natural rubber, polyisoprene, butyl rubber, halogenated butyl rubbers, polybutadiene, styrene-butadiene rubber, nitrile rubber, hydrated nitrile rubber, chloroprene rubber, ethylene-propylene (EPM) rubber, ethylene-propylene-diene (EPDM) rubber, epichlorohydrin rubber, polyacrylic rubber, silicone rubber, fluorosilicone rubber, fluoroelastomers, perfluoroelastomers, polyether block amides, tetrafluoroethylene/propylene rubbers, chlorosulfonated polyethylene, ethylene-vinyl acetate, thermoplastic elastomers, thermoplastic vulcanizates, polyurethane rubber, polysulfide rubber, and the like.

As shown in FIG. 1, an adhesive 80 may be disposed between surfaces of clamping member 38 and dampening member 30 to secure dampening member 30 to clamping member 38 and to prevent lateral (side-to-side) movement of dampening member 30 with respect to clamping member 38.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An electronic assembly comprising:
a circuit substrate;
an electronic component having a body and electrical leads extending from the body, the body of the electronic component having an upper surface and sidewalls substantially perpendicular to an upper surface of the circuit substrate, the leads of the electronic component soldered to the circuit substrate to create solder connections;
an elastic dampening member, the dampening member having a top section engaging the upper surface of the electronic component and opposite end walls that extend downwardly from the top section of the dampening member and engage the opposite sidewalls of the body of the electronic component; and
a clamping member that compresses the dampening cover between the clamping member and the electronic component and urges the opposite end walls of the dampening member against the opposite sidewalls of the electronic component.

2. The electronic assembly of claim 1, wherein the clamping member forcefully engages an upper surface of the opposite end walls and urges lower ends of the end walls of the dampening member against the sidewalls of the body of the electronic component, and wherein the clamping member is vertically spaced away from at least a central section of the top of the dampening cover, whereby the electronic component is securely gripped between the opposite end walls of the dampening member without exerting substantial force on the solder joints when the electronic assembly is subjected to shock and/or vibration.

3. The electronic assembly of claim 1, wherein the elastic dampening member is comprised of an elastomer.

4. The electronic assembly of claim 1, wherein the elastically compressible dampening member is comprised of silicone rubber.

5. The electronic assembly of claim 1, wherein the clamping member is a housing member fixed to the circuit substrate, the clamping member and circuit substrate together defining a volume in which the electronic component is contained.

6. The electronic assembly of claim 1, wherein an adhesive is disposed between a surface of the clamping member and a surface of the dampening member.

7. The electronic assembly of claim 1, wherein the electronic component is a capacitor.

8. The electronic assembly of claim 1, wherein the electronic component is supported on the circuit substrate, in spaced relation to the circuit substrate, with supporting end plates welded to the opposite sidewalls of the electronic component.
